# EUROPEAN PATENT APPLICATION

(11) **EP 4 495 994 A1**
(43) Date of publication of application: **22.01.2025**
(21) Application number: 24189651.3
(22) Date of filing: 19.07.2024
(51) Int. Cl.: H01L 23/473, H01L 23/498

(54) **STRUCTURE AND METHOD FOR INTEGRATING THROUGH METAL CONTACTS AND FLUID CHANNELS**

(30) Priority: 21.07.2023 US 202363514860 P; 30.10.2023 US 202318497117
(71) Applicant: Avago Technologies International Sales Pte. Limited, Singapore 768923 (SG)
(72) Inventor: Theil, Jeremy Alfred, Irvine, 92618 (US); Mayukh, Mayank, Irvine, 92618 (US)
(74) Representative: Dilg, Haeusler, Schindelmann Patentanwaltsgesellschaft mbH

(57) **Abstract**

Technical solutions can provide convective cooling of a heat generating circuit (210) through fluid channels (250) formed beneath the circuit (210) and alongside through substrate vias (TSVs). A plurality of parts of TSVs can be etched perpendicularly inside of a surface of a first substrate, where each of the parts of TSVs can be spaced apart from other parts of the TSVs by a set pitch. A plurality of fluid channels (250) can be etched in the same first substrate, each one of which can be located between one or more of the parts of TSVs. A second substrate (265) including a matching set of parts of TSVs can be bonded to the surface of the first substrate to seal the plurality of fluid channels (250) along the surface of the first substrate and complete the TSVs formation. The plurality of fluid channels (250) can dissipate heat from the circuit (210) in thermal contact with the first substrate.

## Description

### CROSS-REFERENCE TO RELATED PATENT APPLICATIONS

This application claims the benefit of and priority to U.S. Provisional Application 63/514,860, filed 7/21/2023, incorporated herein by reference in its entirety.

### TECHNICAL FIELD

This disclosure generally relates to systems and methods of forming semiconductor devices, including without limitation integration of semiconductor devices through metal contacts and fluid channels.

### BACKGROUND

Semiconductor devices can be designed in a variety of ways and for a variety of applications. Semiconductor devices can generate heat, which unless dissipated, can adversely affect the performance of these devices. Depending on the design, semiconductor devices can be integrated with other circuits or systems.

### SUMMARY

Integrating a circuit, such as a semiconductor integrated circuit (IC), into a package or a system can be challenging, especially when dealing with high-power-density ICs generating an amount of heat that air cooling alone may not sufficiently dissipate. Such heat generating circuits can be powered or connected to vertically oriented, electrically conductive contacts, sometimes referred to as through substrate vias or TSVs, which can be routed beneath the circuits. By virtue of being routed beneath the circuits, TSVs can occupy the space in the material beneath the circuits, thereby preventing or interfering with structures that can be used for effective heat dissipation from the circuits. The technical solutions of the present disclosure overcome these challenges by implementing fluid channels providing fluid convective cooling beneath a heat generating circuit, while facilitating routing, alongside the channels, the TSVs for providing electrical connectivity to the circuit. For instance, the technical solutions provide an improved and effective heat transfer path for dissipating the heat from the circuit to the fluid moved via one or more channels or passages disposed in parallel with the plane of the circuit, thereby providing efficient cooling to the circuit, while also preserving the space for TSVs to be routed orthogonally alongside the fluid channels.

An aspect of the technical solutions is directed to a system. The system can include a plurality of electrical contacts etched perpendicular with respect to a surface of a first substrate. Each of the plurality of electrical contacts can be spaced apart from each other one of the plurality of electrical contacts. The system can include a plurality of fluid channels etched along the surface of the first substrate. Each of the plurality of fluid channels can be etched between one or more of the plurality of electrical contacts. The system can include a second substrate bonded to the surface of the first substrate to seal the plurality of fluid channels along the surface of the first substrate. The plurality of fluid channels can dissipate heat from a circuit in thermal contact with the first substrate.

The plurality of fluid channels can be sealed between at least the first substrate and the second substrate to facilitate movement of a fluid through the plurality of channels to convect (e.g., dissipate via convection) the heat away from the circuit. The system can include a plurality of fins formed in the first substrate. Each of the plurality of fins can be separated from each other fin of the plurality of fins by a fluid channel of the plurality of fluid channels. Each respective fin of the plurality of fins can enclose two or more electrical contacts of the plurality of electrical contacts. Each respective two or more electrical contacts of each respective fin can extend vertically along a height of each respective fin.

The system can include a device die comprising the circuit having an interconnect layer on a first surface of the device die. A second surface of the device die can be bonded with a second surface of the first substrate to conduct the heat from the circuit to a fluid moved through the plurality of fluid channels, via the second surface of the device die and the second surface of the first substrate.

The system can include a second plurality of electrical contacts etched perpendicular with respect to a surface of the second substrate. The surface of the second substrate can be bonded with the surface of the first substrate to axially align and couple each of the second plurality of electrical contacts with at least one of the plurality of electrical contacts of the first substrate. The circuit can be configured to communicate a plurality of electrical signals via the plurality of electrical contacts and the second plurality of electrical contacts in electrical continuity with the plurality of electrical contacts.

The system can include an inlet port to input a fluid into the plurality of fluid channels. The system can include an outlet port to output the fluid out of the plurality of fluid channels. The system can include a device configured to move the fluid, via the inlet port, through the plurality of fluid channels and out of the outlet port. The fluid can be input via the inlet port at a first temperature and output via the outlet port at a second temperature higher than the first temperature.

The system can include a second plurality of fluid channels etched along a surface of the second substrate bonded to the first substrate. Each of the second plurality of fluid channels can align with each respective fluid channel of the plurality of fluid channels to form a combined plurality of fluid channels.

Each combined channel of the combined plurality of fluid channels can include a cross section whose height includes a sum of a height of a respective channel of the plurality of channels and a height of a respective channel of the second plurality of channels. The cross section can have a width corresponding to a width of one of the respective channel of the plurality of channels or a width of the respective channel of the second plurality of channels.

Each of the second plurality of fluid channels can be etched between one or more of a second plurality of electrical contacts etched perpendicular with respect to the surface of the second substrate. Each of the second plurality of electrical contacts can be aligned with a respective of the plurality of electrical contacts of the first substrate.

An aspect of the technical solutions is directed to a method. The method can include etching a plurality of electrical contacts perpendicular with respect to a surface of a first substrate. Each of the plurality of electrical contacts can be spaced apart from each other of the plurality of electrical contacts. The method can include etching a plurality of fluid channels along the surface of the first substrate. Each of the plurality of fluid channels can be etched between one or more of the plurality of electrical contacts. The method can include bonding a second substrate to the surface of the first substrate to seal the plurality of fluid channels along the surface of the first substrate. The method can include providing a thermal contact between a circuit and the first substrate to facilitate the plurality of fluid channels to dissipate heat from the circuit.

The method can include sealing the plurality of fluid channels between at least the first substrate and the second substrate to facilitate movement of a fluid through the plurality of channels to convect (e.g., dissipate via convection) the heat away from the circuit. The method can include forming a plurality of fins in the first substrate. Each fin of the plurality of fins can be separated from each other fin of the plurality of fins by a fluid channel of the plurality of fluid channels. The method can include enclosing, by each fin of the plurality of fins, two or more electrical contacts of the plurality of electrical contacts. The respective two or more electrical contacts enclosed by each respective fin can extend vertically along a height of the each respective fin.

The method can include bonding a second surface of a device die with a second surface of the first substrate. The bonding can be implemented to conduct the heat from the circuit, via the second surface of the device die and the second surface of the first substrate, to a fluid moved through the plurality of fluid channels. The device die can include the circuit having an interconnect layer on a first surface of the device die.

The method can include etching a second plurality of electrical contacts perpendicular with respect to a surface of the second substrate and axially aligning each of the second plurality of electrical contacts with at least one of the plurality of electrical contacts of the first substrate. The method can include bonding the surface of the second substrate with the surface of the first substrate to couple each of the second plurality of electrical contacts with the at least one of the plurality of electrical contacts of the first substrate. The circuit can be configured to communicate a plurality of electrical signals via the plurality of electrical contacts and the second plurality of electrical contacts in electrical continuity with the plurality of electrical contacts.

The method can include etching an inlet port to input a fluid into the plurality of fluid channels and etching an outlet port to output the fluid out of the plurality of fluid channels. The method can include moving, by a device, the fluid via the inlet port, through the plurality of fluid channels and out of the outlet port, the fluid input via the inlet port at a first temperature and output via the outlet port at a second temperature higher than the first temperature.

The method can include etching a second plurality of fluid channels along a surface of the second substrate to be bonded to the first substrate. The method can include aligning each of the second plurality of fluid channels with each respective fluid channel of the plurality of fluid channels to form a combined plurality of fluid channels. Each combined channel of the combined plurality of fluid channels can include a cross section whose height includes a sum of a height of a respective channel of the plurality of channels and a height of a respective channel of the second plurality of channels. The cross section can have a width corresponding to a width of one of the respective channel of the plurality of channels or a width of the respective channel of the second plurality of channels.

The method can include etching a second plurality of electrical contacts etched perpendicular with respect to the surface of the second substrate. Each of the second plurality of electrical contacts can be aligned with a respective of the plurality of electrical contacts of the first substrate. The method can include etching a second plurality of fluid channels along a surface of the second substrate to be bonded to the first substrate. Each of the second plurality of fluid channels can be etched between one or more of the second plurality of electrical contacts.

An aspect of the technical solutions is directed to a device for cooling a circuit. The device can include a first semiconductor substrate having a first metal component extending from a first surface of the first semiconductor substrate toward an interior of the first semiconductor substrate. The first semiconductor substrate can include a channel etched into and along the first surface of the first semiconductor substrate. The device can include a second semiconductor substrate having a second metal component extending from a first surface of the second semiconductor substrate towards an interior of the second semiconductor substrate. The device can include an interface along which the first surface of the first semiconductor substrate is bonded with the first surface of the second semiconductor substrate to seal a fluid inside the channel between the first semiconductor substrate and the second semiconductor substrate and form a metal via from the first metal component coupled with the second metal component. The device can include a device die in thermal contact with the first semiconductor substrate via a second interface along which the device die is bonded with a second surface of the first semiconductor substrate to dissipate heat generated by a circuit in the device die to the fluid in the channel and electrically connect the metal via to the circuit.

The device can include a plurality of channels comprising the channel. The plurality of channels can be etched along the first surface of the first substrate. The device can include an inlet port to facilitate input of the fluid into the plurality of channels. The device can include an outlet port to facilitate output of the fluid from the plurality of channels.

### BRIEF DESCRIPTION OF THE DRAWINGS

These and other aspects and features of the present embodiments will become apparent to those ordinarily skilled in the art upon review of the following description of specific embodiments in conjunction with the accompanying figures.
FIG. 1 is an example of a system that includes a device on a package substrate, in accordance with aspects of the technical solutions.
FIG. 2 illustrates multiple views of an example device or a structure with cooling fluid channels alongside TSVs, in accordance with aspects of the technical solutions.
FIG. 3 illustrates additional views of example devices or structures with convection cooling fluid channels alongside TSVs, using, for example, stacked wafers arrangement, in accordance with aspects of the technical solutions.
FIG. 4 illustrates examples of devices or structures with inlet and outlet ports for fluid channels for convection cooling, in accordance with aspects of the technical solutions.
FIG. 5 is an example process flow for manufacturing or fabricating an example device or a structure including fluid channels alongside TSVs, in accordance with aspects of the technical solutions.
FIG. 6 is a continuation of the example process flow for manufacturing or fabricating an example device or a structure including fluid channels alongside TSVs, in accordance with aspects of the technical solutions.
FIG. 7 illustrates an example of a structure or a device, in accordance with aspects of the technical solutions.
FIG. 8 illustrates an example of a structure or device, in accordance with aspects of the technical solutions.
FIG. 9 is an example of a structure or device using a fluid moving device to move fluid through the convection cooling fluid channels, in accordance with aspects of the technical solutions.
FIG. 10 illustrates an example flow diagram of a method for providing forced fluid convection cooling via one or more channels disposed alongside vertically oriented vias to a heat generating circuit.

### DETAILED DESCRIPTION

The present embodiments shall now be described in detail with reference to the drawings, which are provided as illustrative examples of the embodiments so as to enable those skilled in the art to practice the embodiments and alternatives apparent to those skilled in the art. Figures and examples below are not meant to limit the scope of the present embodiments to a single embodiment, but other embodiments are possible by way of interchange of some or all of the described or illustrated elements, or those apparent to a person of ordinary skill in the art. Certain elements of the present embodiments can be partially or fully implemented using known components, only those portions of such known components that are necessary for an understanding of the present embodiments shall be described, and detailed descriptions of other portions of such known components will be omitted so as not to obscure the present embodiments. Embodiments described in their illustrated contexts should not be limited thereto. For example, embodiments described as being implemented in semiconductor substrate should not be limited to such implementation alone, but they can include embodiments implemented in various types of substrates and other materials, as will be apparent to those skilled in the art, unless otherwise specified herein. In the present specification, an embodiment showing a singular component should not be considered limiting; rather, the present disclosure is intended to encompass other embodiments including a plurality of the same component, and vice-versa, unless explicitly stated otherwise herein. Moreover, applicants do not intend for any term in the specification or claims to be ascribed an uncommon or special meaning unless explicitly set forth as such. Further, the present embodiments encompass present and future known equivalents to the known components referred to herein by way of illustration.

Integration of heat generating circuits, such as semiconductor integrated circuit (ICs), into a package or a system can be a challenge. When designing high power density ICs, it can be advantageous to extract the heat generated by the ICs using forced convection cooling, particularly in higher power ICs which tend to produce an amount of heat that may not be adequately cooled by air alone. In addition, high power ICs can also receive their electrical signals (e.g., power supply lines or electrical signal lines) through electrically conductive contacts that can be vertically oriented in part with respect to the plane of the substrate of the IC. Such vertically oriented contacts can also be referred to as the through substrate vias (TSVs) and can be routed through the material beneath the ICs. As the material beneath the IC can be used by a large number of TSVs, it can be difficult to provide a path for sufficient heat dissipation and cooling of the IC through the same material. In such configurations, it can be beneficial to simultaneously maximize the heat transfer through the material beneath the ICs while also facilitating electrical connectivity to the IC.

The technical solutions provided herein overcome these challenges by utilizing etching and substrate bonding techniques to provide fluid channels for forced convection cooling alongside TSVs that can be formed in vertical orientation to provide electrical connectivity to the high power IC. In doing so, the technical solutions can improve both the heat transfer coefficient to the fluid pumped through the fluid channels beneath the IC, while also facilitating or improving the density TSV routing to the IC in the same material beneath the ICs. The technical solutions can utilize, for example, hybrid bonding (e.g., at interfaces between different substrates, such as die, wafers, interposers or other stacks of material) to form a parallel array of fluid channels enclosing and sealing a cooling fluid inside of the one or more channels (e.g., the parallel channel array network).

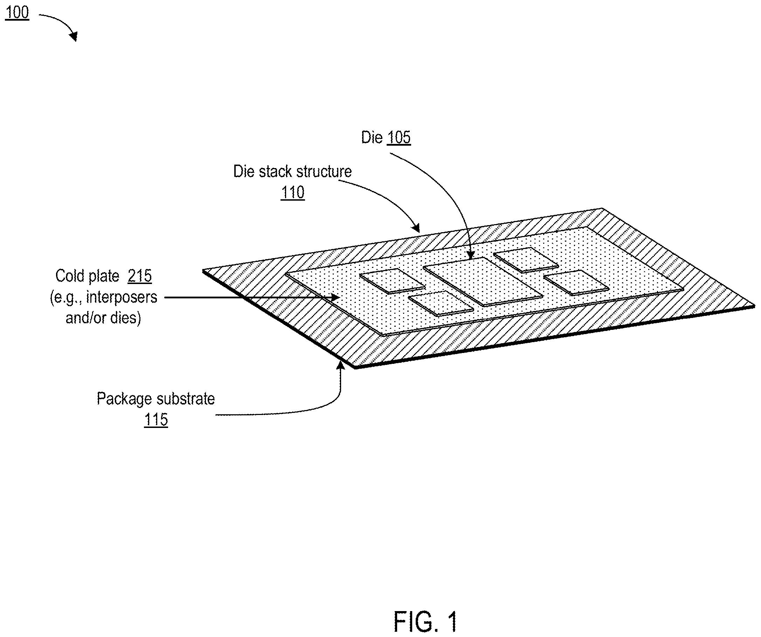

FIG. 1 illustrates an example device, structure or a system 100 of the technical solutions in which a die or die stack 105 can be provided in a die stack structure 110 supported on a cold plate 215 that can be mounted on a package substrate 115. Example system 100 can include a package substrate 115 that is coupled with, and in thermal or physical contact with, cold plate 215. Thermal and/or physical contact can be formed between die 105 and interposer 120. Cold plate 215 can include one or more substrates, interposers or dies that can form a die stack structure 110 together with die 105 that can include a circuit 210 generating heat. Die structure 110 can include any number of layers formed by any combination of substrates, interposers and dies. Integrated in the material between at least a portion of a die 105 and at least a portion of the cold plate 215 can be through metal contacts or vias (e.g., TSVs) and one or more passages for conducting fluid (e.g., fluid channels) to provide convective cooling to the circuits 210 in the die 105. The technical solutions can include a package substrate 115 supporting thereon any number of heat generating circuits or devices, such as the die 105.

A die 105 can include any semiconductor component that includes an electronic circuit 210 (e.g., an integrated circuit) that can be fabricated on, or within, a piece of a semiconductor material. Die 105 can include any substrate material, such as a semiconductor substrate, including for example a silicon substrate, a gallium arsenide substrate, a silicon carbide substrate, a gallium nitride substrate or any other substrate used for circuit manufacturing. Die 105 can include, for example, any one or more circuits implemented in, or on, or within, the substrate, such as a processor, a controller, a power supply, an analog and/or a digital circuit having any combination of logic gates and active or passive electronic components (e.g., resistors, capacitors, inductors), circuits for performing arithmetic functions, memory cells, flip-flop and latches circuits or clock circuitry for a processing unit or a system. Die 105 can include a single physical part of a semiconductor substrate, processed to include one or more circuits and configured for connecting to contact lines (e.g., via pads or vias) and interfacing with other devices, components or systems.

Cold plate 215 can include an interposer 120 or a die having a material (e.g., a substrate) inside of which high-density electrical connections and signal routing between circuits (e.g., ICs) or semiconductor dies can be formed within a single package. Interposer of a cold plate 215 can include, for example a silicon interposer, such as a thin layer of silicon material with a network of interconnects, or any other semiconductor substrate material. Interposer can include, for example, a semiconductor interposer for 2.5D or 3D integration, which can be configured or used to stack multiple dies 105 on top of one another (e.g., to form a die stack structure 110). 2.5D integration can include placing multiple integrated circuits on an interposer or substrate and can utilize through-silicon vias (TSVs) for vertical electrical connections. 2.5D integration can use an underlying structure assembled, such as having multiple circuits together on a common substrate that are side-by-side. 3D integration can include a structure in which multiple integrated circuits 210 are stacked on top of one another, such as processors, memory, logic or sensors. The cold plate 215 can include any or all of the functionality of an interposer 120. Once assembled, cold plate 215 can include passages for fluids. Cold plate 215 can interconnect multiple circuit element, such as a memory, logic and sensors.

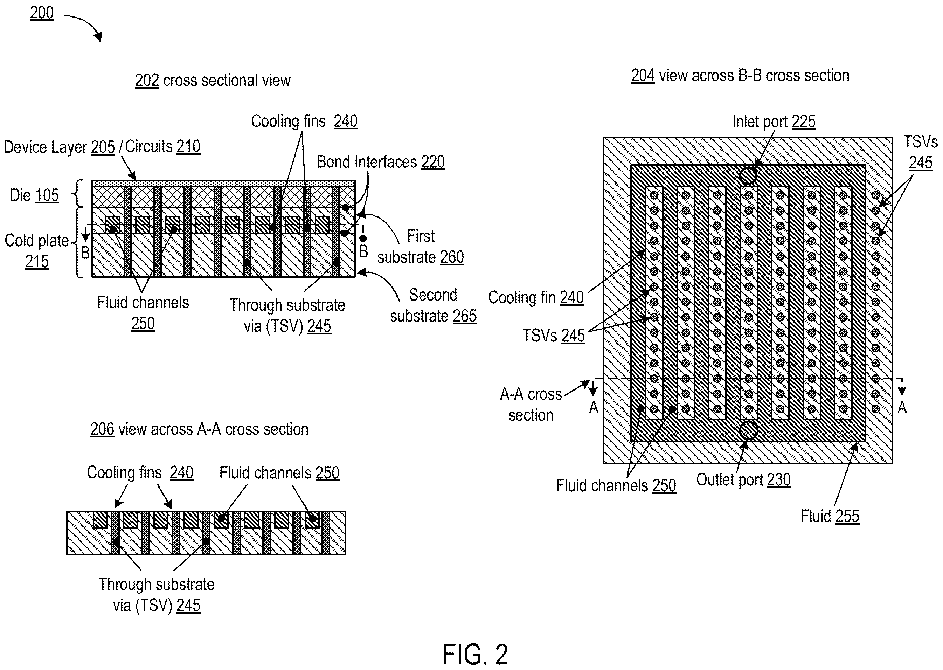

Interposers, substrates or dies of cold plate 215 can include, for example, one or more metal contacts and channels integrated therein. Cold plate 215 can include one or more substrates or dies mounted, coupled, integrated or formed on top of one another, forming a die stack structure 110. Any of the substrates, interposers or dies 105 in the die stack structure 110 can include metal contacts and channels (e.g., fluid channels shown in FIG. 2) which can be integrated therein, such as on top of any dies 105, below any dies 105 or in between any of the dies 105 (e.g., to cool their corresponding ICs). The technical solutions can apply to the system 100 or any portion of it, such as below or above any top die 105, any bottom die 105, or within any layer of the die stack structure 110, including any material in between the dies 105, such as one or more interposers 120.

FIG. 2 provides example device, system or structure 200 for integration via metal contacts for electric connectivity and fluid channels for thermal management. Example 200 illustrates features of the device or system 200 using a cross sectional view 202, a view across a B-B cross section (e.g., plan view) 204, and a view across A-A cross section 206. The system or structure 200 can include multiple substrates bonded together to provide cooling of a circuit or a device via fluid channels, while also facilitating metal vias routed beneath the circuit or device and comprising at least portions that are vertically oriented (e.g., perpendicular) with respect to the plane of the die 105 or the device layer 205.

View 202 illustrates a cross-sectional view of a structure or device 200 having a device layer 205 with one or more circuits 210 in a die 105 that is mounted, attached, bonded or otherwise coupled on top of a cold plate 215 via a bond interface 220. Substrate (e.g., wafer) bonding can include any precise and permanent attachment of two or more substrate (e.g., semiconductor wafers) to form a single integrated structure (e.g., structure 200 or die stack structure 110). Substrate bonding or bonding of substrate surfaces may not necessarily include bonding of the surfaces directly to one another (e.g., placing them in a direct physical and/or thermal contact). Instead, bonding of substrates or materials can occur through intervening layers, materials.

Cold plate 215 can be formed by a first substrate 260 bonded to a second substrate via another bond interface 220. First substrate 260 and the second substrate 265 can include through substrate vias (TSVs) 245 that can be routed vertically or perpendicularly with respect to the plane of the die 105 or substrates 260 and 265. First substrate 260, located between the die 105 on top and second substrate 260 below, can include one or more fluid channels 250 through which fluid 255 can be moved or propagated in order to provide fluid-based convection cooling to the circuit 210. A first bond interface 220 (e.g., between die 105 and first substrate 260) and a second bond interface 220 (e.g., between first substrate 260 and second substrate 265) can be represented or described using a B-B cross-sectional line according to which a 204 view is presented.

Die 105, which can also be referred to as a device die 105, can include a device layer 205 that can include any number of circuits 210. Device layer 205, which can also be referred to as an interconnect layer, can include a layer of die 105 (e.g., semiconductor substrate) in which integrated circuits (e.g., 210) can be formed. Device layer 205 can include a layer of the die 105 (e.g., on top of the top surface of the die) representing a plane in which the circuit(s) 210 are implemented or disposed. Device layer 205 can be on a top surface of the die 105, underneath or within the die 105 (e.g., within the substrate of the die), at the bottom surface of the die 105, or in any combination of the top surface, the bottom surface or the material between the top and the bottom surface of the die 105.

Circuit 210 can include any combination of interconnected electronic components or conductive and semiconductive materials or features configured to perform specific electrical functions. Circuit 210 can include any combination of electrical or electronic components, features for creating, processing, controlling, adjusting, receiving or transmitting electrical signals. Circuit 210 can include a digital logic circuit, an analog circuit, a microprocessor circuit, a radio frequency (RF) circuit, a power management circuit, a sensor circuit, memory circuitry or any other circuitry implemented in a die 105. During its operation circuit 210 can produce heat, which can adversely affect operation of the circuit 210 or any other neighboring circuitry, unless dissipated, such as via fluid channels 250 in the cold plate 215.

Fluid channels 250, also referred to as channels 250, can include any pathway or conduit designed to allow the flow of a fluid (e.g., liquid or gas) to provide cooling. Fluid channel 250 can include a trench etched in a substrate (e.g., first substrate 260) that is sealed by another substrate (e.g., second substrate 260) via wafer bonding (e.g., along a bonding interface 220. Etching can include any selective removal of material from a surface of a substrate, such as by using dry or wet etch processes to create patterns (e.g., holes for TSVs, trench lines for channels, or any other shapes or features) by removing material from the surface of the substrate. Fluid channels 250 can enclose a fluid 255 (e.g., liquid or gas) within all sides, providing only an entrance and an exit, through which the fluid 255 can be moved, forced, pressured or pushed to flow via the fluid channels 250. Fluid channels 250 can be configured to facilitate or provide cooling to from beneath a die 105 or its circuits 210. Channels 250 can be arranged in a parallel array, oriented in a parallel plane with a plane of the die 105, allowing for a multi-channel cooling system beneath the die 105.

Cooling fins 240 can be formed in two-dimensional arrays of fins and pillars to facilitate fluid flow and heat transfer. The dimensions of these fins can be the same or different in different axes and they could be irregularly shaped if desired. Channels 250 can also be arranged to form a channel (e.g., a single flow path) beneath the die, such as a serpentine path, forming for example a zigzag pattern that has one or more turns or direction changes to span or cover an area underneath the circuit. Channels 250 can also be arranged to effectively flow through the entire region of the die, or just part of it. Channels 250 can contain any combination of topologies, such as one or more channels 250 having any type of shapes or routes, including straight lines, curvatures, same or different widths, heights or lengths.

Channels 250 can be etched or machined into a substrate 260 and/or substrate 265. Channels 250 can be configured or designed to form a network of passages through which a cooling fluid 255 (e.g., liquid coolant or gas) can flow. The network of passages can include a single channel 250, a plurality of parallel channels 250, an array or grid of channels 250, a single serpentine, winding or a curvilinear shaped (e.g., curved, zig-zag or s-shaped) channel with straight line channel sections and curved channel portions to cover or span an area or a volume, or any arrangement, shape or orientation beneath the die 105.

In some examples, a serpentine (e.g., single) channel may or may not form fins. In some instances, the design can include an array of fins. For example, a design can include a single row of fins. The design can include an array of fins that can are not orthogonal with respect to the TSVs. For instance, design can include one or more interweaved 2-D arrays of fins that are offset, and that can have a hexagonal or aperiodic lattice, or be uniquely spaced apart.

When the circuits 210 in the die 105 generates heat during operation, the cooling fluid 255 can circulate through the channels 250. Having its initial temperature lower than the temperature of the surrounding material (e.g., substrates 260 and/or 265), fluid 255 can absorb the heat as it passes beneath the die 105. The heat can be transported away from the die 105, via the fluid that is heated in the process, and taken out of the structure 200. Fluid channels 250 can include paths in any shape, such as straight or curved channels, rectangular or circular channels; cross-sections can also have any shape, such as a square, a rectangle, trapezoid, hexagon, a circle, an oval or any other shape of the cross-section of the interior of the channel 250. If etch channel walls extend into more than one substrate, some alignment offset across the bond interface is permissible as long as it does not affect fluid flow.

Fluid 255 can include any fluid, such as a gas or a liquid, for cooling the structure 200 or its components and features. Fluid 255 can include a water or air, a fluorocarbon liquid, an oil, such as a mineral oil, or a refrigerant. Gases can be under pressure but not so high pressure as to cause mechanical failure. As the fluid 255 can be pumped, pushed or moved through the one or more channels 250 via a fluid moving device (e.g., a cooling pump or a fan device), the fluid 255 can be replenished in the channels 250.

Through substrate vias (TSVs) 245, also referred to as vias 245, can include any conductive material, electrical contact, or electrically conductive pathway inside of one or more semiconductor substrates. TSVs 245 can one or more (e.g., interconnected) electrical contacts providing a pathway for electrical signals routed beneath and coupled with a die 105. A TSV 245 can include a metal material deposited or filled inside of a hole or through-hole of one or more substrates (e.g., 105, 120, 260 or 265) to provide an electrically conductive pathway. Vias 245 can be oriented or arranged into a direction vertical with respect to the die 105 and/or substrates 260 or 265. TSV 245 can be formed by etching vertically oriented (e.g., downward) holes or cavities in a first substrate 260 and a second substrate 265 and filling each of the holes or cavities with electrically conductive material (e.g., copper, nickel, or tungsten, or any other electrical conductor).

TSV 245 can be formed by combining a first part of a TSV from the first substrate 260 and a second part of a TSV from the second substrate 265. The two parts of the TSV from the two substrates can be aligned (e.g., coaxially and end-to-end) to connect them to each other using substrate bonding. For example, two substrates can be bonded using one or more zero-clearance bonding techniques (e.g., zero-clearance hybrid bonding) in which two surfaces or substrates are joined together with minimal gaps or separation, such as where any separation or gaps are limited to a nanometer scale or to atomic (e.g., sub-nanometer) scale. Zero-clearance bond can connect two or more materials, where some materials include one or more electrical conductors and/or one or more electrical insulators. For instance, a zero-clearance bond can be used such that an insulator material and a conductor material are placed in contact or bonded. The conductors can be made of more than one material, including for example conductive barriers. Insulators can be made up of multiple layers as well of insulating materials.

The TSVs can be connected directly to one another, or one or more of them can have metal bonding pads formed over them using zero-clearance bonding structures and methods. As a result, a TSV 245 can include a first part of a via routed through a first substrate 260 and a second part of the via routed through the second substrate 260. The two parts of the TSV 245 can be coaxially aligned with each other so as to form a single, straight via (e.g., column or line of metal) being seamlessly connected to each other through alignment and/or fusion or bonding. TSVs 245 can be formed using plurality of parts or portions that can be axially aligned (e.g., be collinear, oriented in a same line or direction and touching end to end), or can be misaligned but electrically coupled, connected or bridged using metal pads or horizontal metal contacts or lines. For instance, the axial alignment can be off center while also being sufficient to form electrical connection so as to conduct electrical signals.

Cooling fins 240 can include any projection, ribs, protrusion, surface roughness, or extended structure for dissipating heat by increasing the surface area exposed to a cooling fluid to facilitate heat transfer. Cooling fins 240 can include any heat dissipating structure designed or used to improve heat transfer from itself to a cooler medium, such as a cooling fluid. Cooling fins 240 can include any combination of substrate materials, such as the first substrate 260 or second substrate 265. Each of the substrates 260 or 265 can include semiconductor substrates (e.g., silicon, gallium arsenide, silicon carbide), glass, or ceramics. Cooling fins 240 can include TSVs 245. Cooling fins 240 can include a projecting structure exposed to, or in physical or thermal contact with, a cooling fluid 255, along one or more sides of the fin.

Thermal contact can include any connection, path or interface between two materials or objects that facilitates heat transfer, whether in direct physical contact or through an intervening thermally insulating structure or medium. For example, thermal contact may or may not include a direct thermal or physical contact. For example, thermal contact can include intervening layers or barriers of thermal insulator material films through which heat can still be conducted or dissipated.

For instance, a cooling fin 240 can include a projection or protrusion of a substrate 260 or 265 surrounded on its one or more adjacent or opposite sides by a fluid 255 flowing within one or more channels 250. Cooling fin 240 can include a surface area in a physical or thermal contact with fluid 255 within one or more channels 250. Cooling fins 240 can include a substrate material having a high thermal conductivity (e.g., between about 50-400 W/m*K, or more than 400 W/m*K) facilitating improved heat transfer. Cooling fins 240 can include one or more TSVs 245, routed vertically through the substrate material (e.g., along the height of the cooling fins) and serving as conduits for the efficient transfer of heat from the electronic components to the substrate. Cooling fin 240 can include or be embedded, perforated or traversed by one or more vias that can extend through the fin. For instance, a cooling fin 240 can include a plurality of TSVs 245 traversing or extending through the cooling fin 240, extending along the height of the TSV 245. TSV 245 can include thermally conductive material and facilitate in heat dissipation from the cooling fin 240 to the fluid 255.

A bond interface 220 can be used to attach, connect, join, couple or bond a die 105 (e.g., device layer 205 or integrated circuit 210) with a substrate (e.g., 260 or 265) in which cooling fins 240 and fluid channels 250 can be formed. Bond interface 220 can be created via wafer bonding of substrates (e.g., dies 105 or substrates 260 or 265), such as for example permanently attaching two semiconductor wafers together into a single integrated structure. Bond interface 220 can be implemented at the atomic or molecular level, such as using direct bonding, adhesive bonding or fusion bonding. The structure 200 can be formed by wafer bonding of the die 105 with one surface of the first substrate 260 and wafer bonding a second substrate 265 with another surface of the first substrate 260 to form the cold plate 215 with the first substrate 260 and the second substrate 265 for the die 105 and its circuit 210. Bond interface 220 can be formed using any number of techniques. For example, bond interface 220 can be implemented using surface activation using a layer of oxide on one or more surfaces to facilitate bonding. Bonding interface 220 can be implemented using direct bonding.

While view 202 shows an example in which the surface of the die 105 having a device layer 205 is turned away from the cold plate 215, it is understood that depending on the design, die 105 can be oriented with respect to the cold plate 215 in either the face up or face down orientations. For example, die 105 can have the surface with the device layer 205 and the circuit 210 turned towards and bonded with the cold plate 215. In such a configuration, the channels 250 can be placed closer to the circuit 210, reducing thermal resistance between the circuit 210 and the channels 250. For example, die 105 can have the surface of the device layer 205 and the surface 210 turned away from the cold plate 215 and having the opposite side of the die 105 bonded with the cold plate 215. In such a configuration, back plane of the die 105 can be in a closer thermal contact with the channels 250 than the device layer 205.

View 204 of FIG. 2, provides a view across a B-B cross sectional line from view 202. View 204 can correspond to a top down view of a device, system or structure 200 showing the planar arrangement of parallel array of channels and TSVs 245 arranged in lines or columns within the cooling fins 240 and traversing through the cooling fins 240 along the height of the cooling fins 240.

As illustrated in view 204, the technical solutions facilitate the routing or providing of TSVs 245 alongside (e.g., in between) the cooling fins 240. Provided or routed beside (e.g., to the left or to the right of) each channel 250 or in between any two channels 250 can be any number of TSVs 245 that can be oriented or routed in a direction that is orthogonal or perpendicular to the plane along which fluid channels 250 are provided.

View 204 illustrates the network or structure of fluid channels 250 having one or more inlet ports 225 and outlet ports 230. Inlet and outlet ports can provide passages for the fluid 255 to enter or exit the fluid channels 250. For example, an inlet port 225 can be provided on one end of one or more channels 250, while an outlet port 230 can be provided on the other (e.g., opposite end or path) of the one or more channels 250. Inlet port 225 or outlet port 230 can be arranged, formed through etching or drilling, and can include a circular, rectangular, elongated or any other shape of the opening or cross-section.

View 206 provides a cross-sectional via along a line A-A shown in the view 204, showing cross-section along a row (e.g., spanning across multiple columns of TSVs 245). View 206 provides a different view of cooling fins 240 having TSVs 245 routed vertically through and along the height of the cooling fins 240. Each TSV 245 can be separated from the channel 250 by a layer or sliver of substrate material (e.g., substrate 260 or 265) forming the cooling fin 240.

The technical solution can use a hybrid bonding surface to connect multiple wafers together and align and form the TSVs 245 and the channels 250, such as by coaxially aligning and bringing in electrical contact different parts or sections of the TSVs 245 (e.g., from different substrates). The technical solution can also align and bring together (e.g., seal) the fluid channels 250 between two or more different substrates. System 200 can use cooling fins 240 or other features (e.g., between the channels 250) to allow passage, routing or disposing of one or more TSVs 245 through the layer of channels 250 (e.g., in between individual channels 250). The technical solutions can use a hybrid bonding surface to connect different wafer substrates together, while TSVs 245 can be formed, etched or drilled through the cooling fins (e.g., fin structures) to facilitate more efficient heat distribution and cooling.

The technical solutions can include or utilize any zero-clearance bond that allows electrical connection of the through substrate. For example, fusion bonding or hybrid copper bonding technology can be used to bond, couple or connect portions of metal vias into a TSV 245. For example, one or more TSVs 245 extending orthogonally through a portion of the cold plate 215 that includes (e.g., a planar array of) fluid channels 250 can provide die side connection to the circuit 210 at the device layer 205. Examples of contacts on the circuit 210 side can include other TSVs 245, and copper bonding/landing pads to which TSVs 245 from the cold plate 215 can connect or electrically couple.

In the cold plate 215, the wafers (e.g., substrates 260 and 265) can be bonded so as to have TSVs 245 that can make contact to other TSVs, or could be connected to other conductive structures, such as landing pads or fan out layers. For instance, pads or other structures can be used as an electrically conductive interface connecting two offset pieces of TSV 245. Cold plate 215 can be made from silicon or any materials (e.g. glass, ceramic, or electrical insulators) or structures that allow TSVs 245 to be electrically isolated from one another. Materials used for TSVs 245 can have high thermal conductivity (e.g., metals, such as copper, tungsten, nickel). Low thermal conductivity materials can be used as thin insulating layers (e.g., 20nm film thickness) if such structures remain sufficiently thermally conductive and if heat transfer can occur across them.

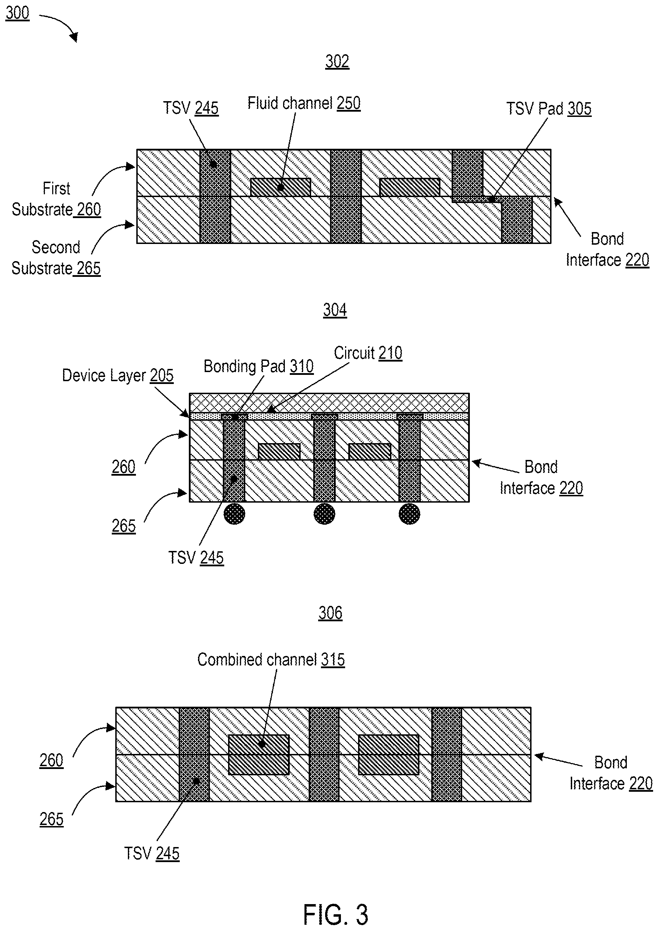

FIG. 3 illustrates various examples of a structure, device or a system, such as system, device or structure 200, including additional design features or variations. As with example 200 in FIG. 2, example 300 can include fluid channels 250 constructed in stacked substrates facilitating the flow of fluid 255. Example 300 can be illustrated using cross-sectional views 302, 304 and 306. While example 300 illustrates a two-wafer substrate design with a single bond interface, the technical solutions allow for construction of more complex flow paths by stacking any number of additional wafers or material on top of one another.

View 302 illustrates a cross-sectional view of bonded first substrate 260 and second substrate 265 (e.g., in a cold plate 215) having TSVs 245 and fluid channels 250, where one of the TSVs 245 includes an electrical lead that enables a lateral shift or spatial offset between two portions of the TSV 245. As shown, for example, in the right side TSV 245, a first part of TSV 245 in a first substrate 260 can be offset laterally (e.g., to the left) from the second part of the TSV 245 in the second substrate 265. To make provide an electrical connection between the two parts of the TSV 245, a TSV pad 305 (e.g., landing pad) can be provided. TSV pad 305 can include a flat area (e.g., a pad) made from electrically conductive material or a trace (e.g., copper), which can be used to provide electrical continuity between the first part of the TSV 245 (e.g., in the first substrate 260) and the second part of the TSV 245 (e.g., in the second substrate 265). TSV connection 305 can include any shape or size to facilitate the connection between the parts of the TSV 245. For example, TSV pad 305 can include a length it corresponding to a portion of a fluid channel 250 which the TSV 245 is to avoid by shifting a portion of it to a side, thereby facilitating the electrical contact (e.g., by providing a metal via) while also not interrupting the fluid channel 250 along which it passes.

As shown in cross-sectional view 304, a die 105 can be oriented face down, having electrical input or output pads of the circuit 210 exposed to TSVs 245 coming up towards the device layer 205 of the die 105 from the first substrate 260 beneath the die 105. Device layer 205 can have any number of electrical input or output pads that can be axially aligned with TSVs 245 and bonded with their corresponding TSVs 245 via bonding pads 310. Bonding pads 310 can include any electrically conductive features or surfaces corresponding to input or output signals or power lines of the circuits 210 to be connected to by the TSVs 245. In some implementations, bonding pads 310 can be formed on the surfaces being bonded at bond interfaces 220, so as to facilitate improved electrical contacts between parts of TSVs being formed. TSVs 245 of the cold plate 215 can make contact to a bonding pad 310 on the device die and be connected, using for example copper bonding. In this configuration, the cold plate 215 can be placed as close to the die 105 as possible (e.g., a tight physical contact).

Signal density of the TSVs 245 can be based on or related to a diameter of TSV 245, and process integration practices for TSV placement as used in the field. For example, TSV 245 can have a diameter of between 1um and 50um, such as 10 um diameter. TSVs 245 can be distributed along a cooling fin 240 at a pitch of between 10 um and 1000um. For example, a 5 um diameter TSV 245 could have a 45 um pitch given example metal density specifications, which can be centered along a cooling fin 240. In some aspects, a cooling fin 240 can include multiple columns of TSVs 245 of any sizes (e.g., diameters) and distributed according to any pitch. As TSV integration specifications evolve to allow for smaller pitch, those new specifications could be used.

Channel 250 can be constructed to have any height or width. For example, a height of a fluid channel 250 can be between 10um and 1000um, such as 300 um. For example, a TSV 245 can be designed such that its diameter is about 10-15 times smaller than its height, such as having an aspect ratio of between 8:1 and 15:1. Channel 250 can have a cross section that can be sized and shaped to minimize fluid impedance and cold plate pressure drop. For instance, a width of the channel 250 (e.g., the size parallel to the plane of the die 105 or bond interface 220) can be between 10um and 5000um, such as on the order of between 50 um and 200 um.

Cooling fins 240 can have a width that can be designed to be sufficiently wide to accommodate the TSVs 245 (e.g., provide bonding surface), but also sufficiently narrow enough to maximize the number of fins to be packed into the device or maximize the cross section of the channels 250 and the flow of fluid 255. For example, if TSV is designed to be 10 um diameter, cooling fins 240 can have a width of between 50 um and 100 um. The arrangement, shape, and distribution of cooling fins 240 can be such that it maximizes pass through area for TSVs 245 and maximize fluid conductance. The high conductance flow (e.g., fluid throughput) and high TSV density can be optimized against one another. For example, for higher heat transfer characteristics the surface area of the channels 250 and the fluid 255 flow rate can be larger, limiting the area or the number of TSVs 245. For example, when the number of TSVs 245 is larger, the cross-section of channels 250 and the fluid 255 throughput can be reduced, allowing for more areas for TSVs 245.

As shown in cross-sectional view 306, when a channel cross section is a limiting factor (e.g., a larger fluid throughput is desired), the surface area of fluid channels 250 can be increased by combining the channels from two substrates. For example, a channel height can be increased by etching channels into both the first substrate 260 and the second substrate 265 and then aligning the etched parts of the channel 250 to form a channel with doubled height (e.g., combined channel 315). Combined channel 315 can include a channel formed from two channels 250 of the same size and shape (e.g., mirror images of each other). Such two channels on two surfaces of the substrates 260 and 265 can be formed into a single combined channel 315 by bonding the two etched sides of the two substrates so that the two parts of the combined channel 315 are aligned.

The technical solutions can utilize thickening of the wafer substrates or etching deeper channels to create combined channels 315 with larger cross sections. The technical solutions can use bonding of multiple (e.g., three or more) wafer substrates together and etching through the intermediary wafers to produce combined fluid channels 315 of greater cross section. For example, a combined channel 315 can include one or more intermediary substrates that are entirely drilled or etched through to be placed between the top and the bottom substrates providing the bottom interior surface and the top interior surface of the channel. These stacking solutions can also be used to reduce the TSV pitch by reducing the diameter of the TSV used for connection. Since the channel thickness encompassing the intermediate substrate can be smaller, the TSV may not have to be as deep. Accordingly, for a given aspect ratio, the TSV diameter can be reduced and so the minimum pitch can be reduced also.

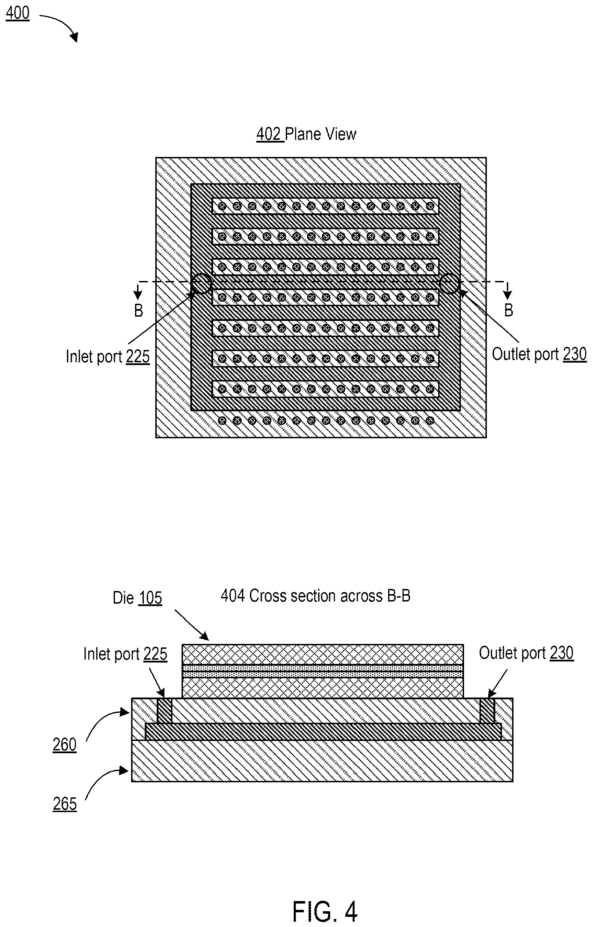

FIG. 4 is an example system, device or structure 400 having inlet and outlet ports shown from a 402 plane view perspective showing a B-B cross-sectional line, as well as from a perspective of a 404 cross section across the B-B line. Device or structure 400 can include any functionality or features of example structures 200 and 300 and vice versa. Example structure 400 can include multiple fluid channels 250 for passing fluid 255 and providing convective cooling.

As shown in 402 plane view of FIG. 4, one or more inlet ports 225 and one or more outlet ports 230 can be created, formed or provided. The technical solutions can be a part of a system that includes any number of inlet ports 225 and outlet ports 230. Shown in views 402 and 404, a cross section B-B shows a configuration of inlet port 225 and an outlet port 230 for the fluid.

As shown in 404, a configuration can include inlet port 225 and outlet port 230 being etched, located or placed from at the bottom or the top wafer, or both. For example, the inlet and outlet ports 225 and 230 can be etched from a surface of the first substrate 260 that bonds to the die 105 (e.g., beside the die 105) downward towards the channel 250. Cross section B-B from views 402 and 404 shows the ports in the first substrate 260, although inlet and outlet ports 225 and 230 can be provided in, or through, the second substrate 265, or any combination of first and the second substrates 260 and 265. In some designs, more than two ports can be used.

In one aspect, the technical solution are directed to a system, device or a structure, including any combination of features described in examples 100-400. The system, device or structure can include a one or more electrical contacts (e.g., TSVs 245) that can be etched perpendicular with respect to a surface of a first substrate 260. Each of the plurality of electrical contacts (e.g., TSVs 245) can be spaced apart from each other of the plurality of electrical contacts (e.g., TSVs 245). The system, device or structure can include a plurality of fluid channels 250 etched along the surface of the first substrate 260. Each of the plurality of fluid channels 250 can be etched between one or more of the plurality of electrical contacts (e.g. TSVs 245). The system, device or structure can include a second substrate 265 that can be bonded to the surface of the first substrate 260 to seal one or more (e.g., a plurality of) fluid channels 250 that can be formed or etched along the surface of the first substrate 260 (e.g., alongside cooling fins 240 formed by the substrates 260 and/or 265). The one or more fluid channels 250 can use the cooling fluid 255 moving within the channels 250 to dissipate the heat generated by the circuit 210, where the heat can be conducted to the one or more channels 250 via a heat path provided by the thermally conductive materials of the die 105 and substrates 260 and 265.

The one or more (e.g., plurality of) fluid channels 250 can be sealed between at least the first substrate 260 and the second substrate 265 to facilitate movement of fluid 255 through the one or more channels 255 in order to transfer the heat away from the circuit 210. For instance, the fluid 255 moving through the channels 250 can be at a first temperature (e.g., 5 or 20 degrees Celsius) which is a lower temperature than the temperature of the circuit 210 (e.g., at 100 degrees Celsius). The heat from the circuit 210 can be conducted away from the circuit 210, via the material of the die 105 and/or substrates 260/265 and via any bond interface 220, to be conducted to the cooling channels 240 and then transferred to the fluid 255 moving through the one or more channels 250.

The system, device or structure can include a plurality of cooling fins 240 that can be formed in the first substrate 260. Each of the plurality of cooling fins 240 can be separated from each other of the cooling fins 240 of the plurality of fins 240 by one or more fluid channels 250 of the plurality of fluid channels 250. Each respective fin 240 of the plurality of fins can include, surround or enclose one or more electrical contacts (e.g., 245) of the plurality of electrical contacts. The one or more or more electrical contacts (e.g., TSVs 245) can extend vertically along a height of each respective fin 240. For instance, a plurality of TSVs 245 can be spaced apart at a pitch of set distances apart (e.g., every 10 um, 20um, 50um, 70um or 100um, 200, or 300) from each other along the length of the cooling fin 240.

The system, device or structure can include a device die 105 including the circuit 210 having an interconnect layer on a first surface of the device die 105. The interconnect layer can include any combination of metal contacts, or vias for the circuit 210. A second surface of the device die 105 can be bonded with a second surface of the first substrate 260 to conduct the heat from the circuit 210, via the second surface of the device die 105 and the second surface of the first substrate 260. For example, a second plurality of electrical contacts (e.g., TSVs 245) can be etched perpendicular with respect to a surface of the second substrate 265. The surface of the second substrate 265 can be bonded with the surface of the first substrate 260 to axially align and couple each of the second plurality of electrical contacts (e.g., 245) with at least one of the plurality of electrical contacts (e.g., 245) of the first substrate. For example, each individual of the TSVs 245 of the first substrate 260 can be coupled with each individual TSV 245 of the second substrate. The circuit 210 can be configured to communicate a plurality of electrical signals via the plurality of electrical contacts (e.g., 245) and the second plurality of electrical contacts (e.g., 245) in electrical continuity with the plurality of electrical contacts (e.g., 245).

The system, device or structure can include an inlet port 225 to input a fluid 255 into the plurality of fluid channels 250 and an outlet port 230 to output the fluid 255 out of the plurality of fluid channels 250. The system or structure can include a device (e.g., FMD 910) that can be configured to move, push or pressure the fluid 255, via the inlet port 225, through the plurality of fluid channels 250 and out of the outlet port 230. The fluid 255 can be input via the inlet port 225 to the channels 250 at a first temperature (e.g., at 10C, which can be at a temperature below a temperature threshold, such as 20C). The fluid 255 can be output via the outlet port 230 at a second temperature (e.g., 70C) that can be higher than the first temperature and above a second temperature threshold (e.g., 50C), where the second temperature threshold is higher than the first temperature threshold to facilitate heat transfer from the circuit 210 to the fluid 255.

The system, device or structure can include a second plurality of fluid channels 250 that can be etched along a surface of the second substrate 265. The second substrate 265 can be bonded to the first substrate 260. The second substrate 265 can have its second plurality of fluid channels 250 aligned (e.g., as a mirror image) with the plurality of channels 250 etched in the first substrate 260. For example, each of the second plurality of fluid channels 250 in the second substrate 265 can align with each respective fluid channel 250 of the plurality of fluid channels 250 in the first substrate 260 to form a combined plurality of fluid channels (e.g., 315). For instance, each combined channel 315 of the plurality of combined channels 315 can include a height having a height of a respective channel 250 from the first plurality of channels 250 and a respective height of a second channel 250 from the second plurality of channels 250.

For example, each combined channel 315 of the plurality of combined fluid channels 315 can include a cross section whose height includes a sum of a height of a respective channel 250 of the plurality of channels (e.g., in the first substrate 260) and a height of a respective channel 250 of the second plurality of channels (e.g., in the second substrate 265). The cross section can have a width corresponding to a width of one of the respective channel 250 of the plurality of channels 250 or a width of the respective channel 250 of the second plurality of channels 250.

Each of the second plurality of fluid channels 250 can be etched between one or more of a second plurality of electrical contacts (e.g., TSVs 245 or part of TSVs 510) which can be etched perpendicular with respect to the surface of the second substrate 265. Each of the second plurality of electrical contacts (e.g., TSVs 245 or part of TSVs 510) which can be aligned with a respective of the plurality of electrical contacts (e.g., TSVs 245 or part of TSVs 510) of the first substrate 260.

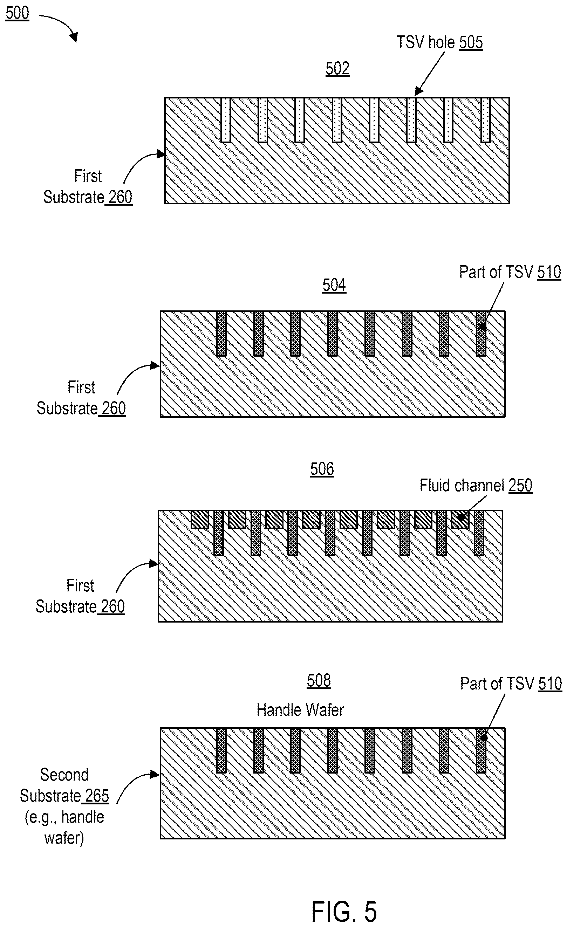

FIG. 5 illustrates an example 500 of a method or process flow for fabricating or forming a device, system or structure, such as example devices, systems or structures 100-400. The process flow can include forming or fabricating fluid channels 250 for passing fluid for convective cooling of a circuit 210, alongside TSVs 245 which can be formed to facilitate electrical connectivity to the circuit 210. Example fabrication flow 500 can be shown using cross sectional views 502, 504, 506 and 508.

At view 502, the fabrication process can include one or more fabrication tasks, which can include depositing silicon-based dielectric and patterning and etching TSV holes 505 to form parts of TSVs 510 inside of the first substrate 260. The parts of TSVs 510 can include portions of the TSVs 245 to be later connected or combined (e.g., via wafer bonding and/or metal bonding techniques) with other parts of TSVs 510 to form full or complete TSVs 245. For example, a mask can be used for exposing a surface of the substrate and etching one or more TSV holes 505 into the substrate. A TSV hole 505 can include any hole (e.g., elongate, shaped as a column or a cylinder and vertically oriented with respect to the top surface) to form a part of a TSV 245 therein. TSV hole 505 can include an etched into the substrate 260 to have an aspect ratio of height to diameter of between 8:1 and 15:1, such as 10:1. TSV hole 505 can be etched into the first substrate 260 according to a pattern. The result can include etched TSV holes for the parts of the TSVs 510 inside of the material of the first substrate 260.

At view 504, the fabrication process can include depositing isolation and depositing seed layers into the TSV hole 505 to form parts of TSVs 510, also referred to as TSV ports or TSV portions. A part of TSV 510 can include a portion of the TSV 245 within a single substrate. Portions of TSVs 510 can be combined to form a TSV 245. The fabrication process for forming parts of TSVs 510 can include depositing TSV metal (e.g., copper) and stabilizing the metal (if desired), thereby filling the TSV holes 505 with the electrically conductive material to form parts of TSVs 510. For example, the fabrication process can include adding more than two substrate layers (e.g., multiple intervening substrates along with their aligned parts of TSVs 510) to form elongate TSVs 245 traversing three or more substates or dies.

At view 506, the first substrate 260 (e.g., having the TSVs 245) can be patterned and etched for fluid channels 250. For instance, using a mask and patterning, fluid channels 250 can be etched along and in between the parts of TSVs 510. The etch process can include a dry process for design flexibility, or it can include a wet process. In some implementations, anisotopic profiles can be used with either dry or wet etching technology. In some implementations, channels 250 can be etched after etching of the TSV trenches and/or creating the parts of TSVs 510 in the substrate. In some implementations, channels 250 can be etched before etching the TSV holes and/or creating the parts of TSVs 510 in the substrate.

At view 508, a second substrate 265 can be used to create the second part of TSV 510 (e.g., to align and connect with the first part of TSV 510 from views 502 and 504). At 508, the fabrication process can include an option in which, the second substrate 265 (e.g., the wafer that will be the handle wafer) can add routing metal into some of the TSV locations. For example, for some TSVs 245, metal can be added or removed. Depending on the fluid flow path, inlet and outlet feeds can be etched into any combination of the second or first substrates (not shown).

In one example, lateral metal can be included as a feature or a part of an interposer in a die stack structure or cold plate. Placement of lateral metal can be independent of the TSVs. Some TSVs can be connected with them. For example, such metal layers can be on either side of either substrate of the cold plate or the die (e.g., device) and they may not interfere with the bonding process.

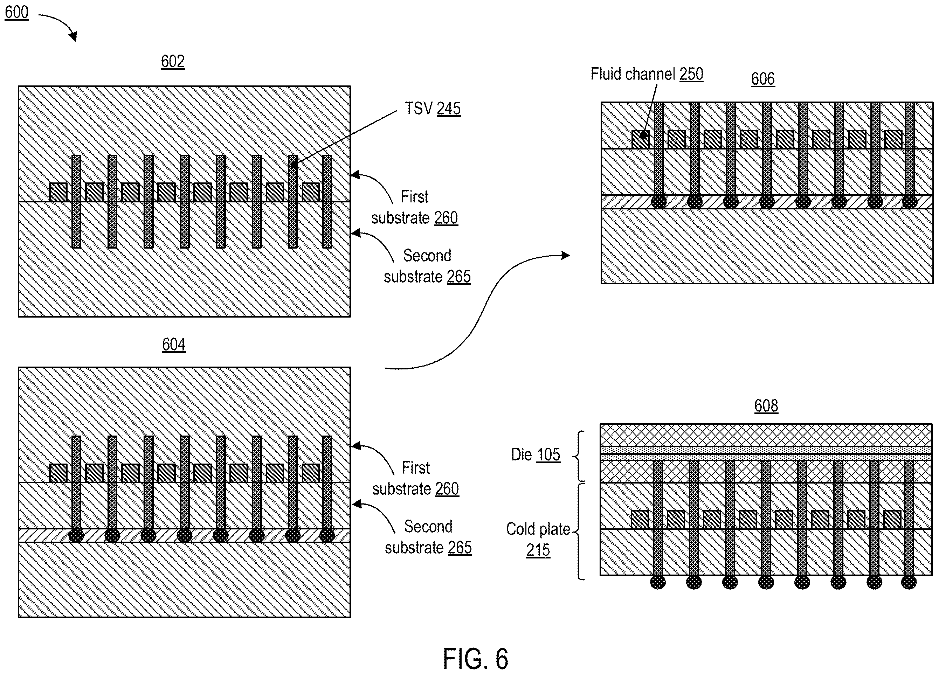

FIG. 6 illustrates a method or process flow 600 which can be a continuation of the method or process flow 500 from FIG. 5, and in which two substrates with their features created in the process flow 500 can be combined by wafer bonding. The method or process flow 600 can include acts or techniques for aligning and bonding the first and the second substrates 260 and 265 to create a cold plate 215. For instance, alignment can be included as a part of a bonding process. For instance, method 600 can include acts or fabrication steps implemented in accordance with views 602, 604, 606 and 608.

At 602, the method or flow can include among other bonding techniques, surface activation based bonding of the first substrate 260 (e.g., the fluid channel wafer) to the second substrate 265 (e.g., the handle wafer). For example, the first and the second substrates can be bonded (e.g., permanently attached to each other) via direct bonding, hybrid bonding, adhesive bonding or fusion bonding. Bonding process may or may not use external pressure to pull the substrates together. In some instances, the amount of force to apply during bonding can include a force that is sufficient to bring the surfaces into contact to enable bond formation, but not exceeding this amount to avoid causing excessive warpage or bow.

At view 604, the second substrate 265 can be thinned or have its thickness reduced. For example, a process flow can be utilized to thin the handle wafer, such as back grinding, chemical mechanical polishing (CMP) or dry etching. For example, the process can go through micro bump (uBump) metallization in which metal bumps or pads can be provided on the substrate surface and use temporary bonds and mounting to a carrier to perform thinning. This process can be done repeatedly (e.g., in a loop) until a desired substrate thickness is achieved.

At view 606, the process can implement a substrate grind to remove the portion of the first substrate 260 that covers the TSVs 245. The process of grinding of the back of the first substrate 260 can be done until the TSVs 245 ae reveal on the top surface. The process can include preparing the surface for bonding. Depending on the flow, the cold plate wafer or the device wafer can be divided (e.g., singulated) into individual pieces prior to bonding (not shown).

At view 608, the process can include the device with a die 105 being bonded top of the first substrate 260 of the cold plate 215. The method can include releasing the handle wafers and temp bond as desired. The resulting structure can include, for example, a die 105 with a surface of the device layer 205 facing towards, and coupling with, the TSVs 245 routed through the cold plate 215. One or more channels 250 can be routed in between the TSVs 245. For example, view 608 can correspond to a single channel 250 routed in a curved, snaked or a zig-zag pattern in between the TSVs 245. For example, view 608 can correspond to a plurality or channels 250 routed in parallel with each other in between the TSVs 245.

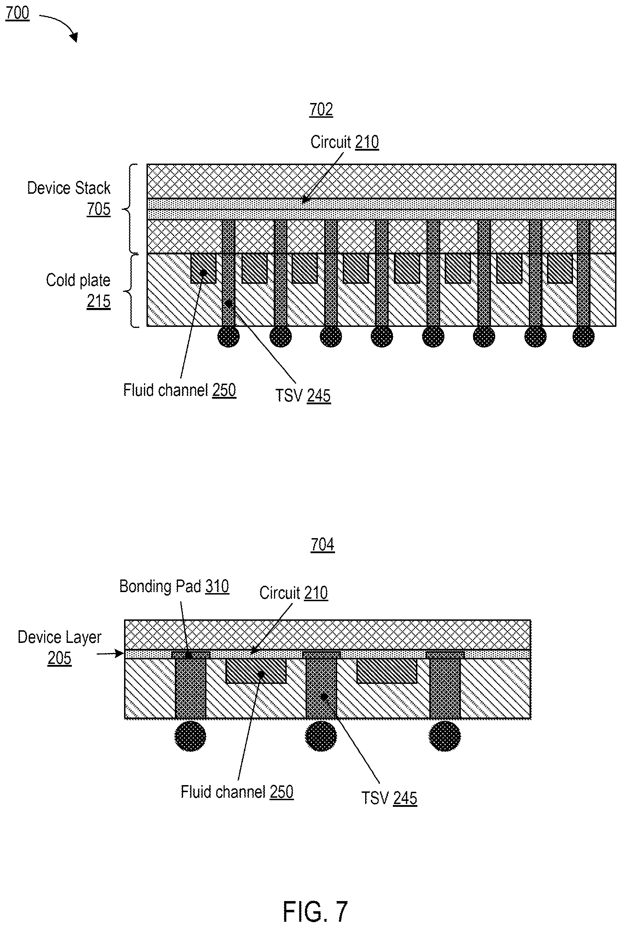

FIG. 7 is an example 700 of a system, structure or device of a single substrate cold plate 215. It is understood that the structure and the bonding can include a wafer to wafer bonding, a die to wafer bonding or a die to die bonding, in any orientation and with any number of layers (e.g., substrates, dies, interposers) involved. Example device, system or structure 700 can be implemented, for example, according to examples illustrated in cross-sectional views 702 and 704. The technical solutions can include a cold plate 215 being manufactured from a single substrate (e.g., substrate 260) where channel(s) 250 can be sealed using the surface of the die 105, rather than another intervening substrate. As a result, the cold plate 215 can include a single monolithic substrate (e.g., first substrate 260) and a structure in which the thermal resistance between the device layer 205 (e.g., with the circuit 210) and the fluid 255 is minimized or reduced, as the cooling fluid 255 can be in a direct physical and thermal contact with the surface of the device die 105 and/or device layer 205, thereby improving the heat transfer from the circuit 210 to the fluid 255.

As shown in view 702, a device stack 705 can include, for example, multiple (e.g., a pair of) dies 105 with their own respective circuits 210, where the dies 105 are stacked one on top of another. Beneath the device stack 705 can be TSVs 245 and channels 250 of the cold plate 215 for providing convective cooling to the device stack 705. Device stack 705 can include a single die 105 that can make up the bottom half of 705, such as in a face up configuration with respect to its device layer 205. The thermal resistance between the device stack 705 and the cold plate 215 can be lower than with any intervening substrates or layers. Using a single wafer cold plate 215, the fluid can be brought in direct contact with the interconnect or the device layer. The interconnect or the device layer surface can be flat enough to enable bonding.

As shown in view 704, bonding pads 310 can be provided as the circuit 210 can be turned downward to face the cold plate 215 allowing for the TSVs 245 to be electrically coupled with electrical contacts of the circuits 210. The device layer, 205, consists of the substrate embedded circuit elements and can additionally include the interconnect between the circuit elements. As the device layer can be turned towards the cold plate (also known as a face down configuration), the thermal resistance between the fluid channel 250 and the device layer 205 can be minimized as the portion of the die 105 that includes or is a device layer 205 can be used to provide the cover (e.g., to seal) the channel 250. In such instances, device layer 205 of a die 105 can be in direct physical and thermal contact with the fluid 255 flowing through the fluid channel 250. In such configurations, device layer 205 can have chemically inert surfaces in contact with the fluid channel 250. A common chemically inert surface can include silicon-based dielectrics such as silicon oxide or silicon nitride.

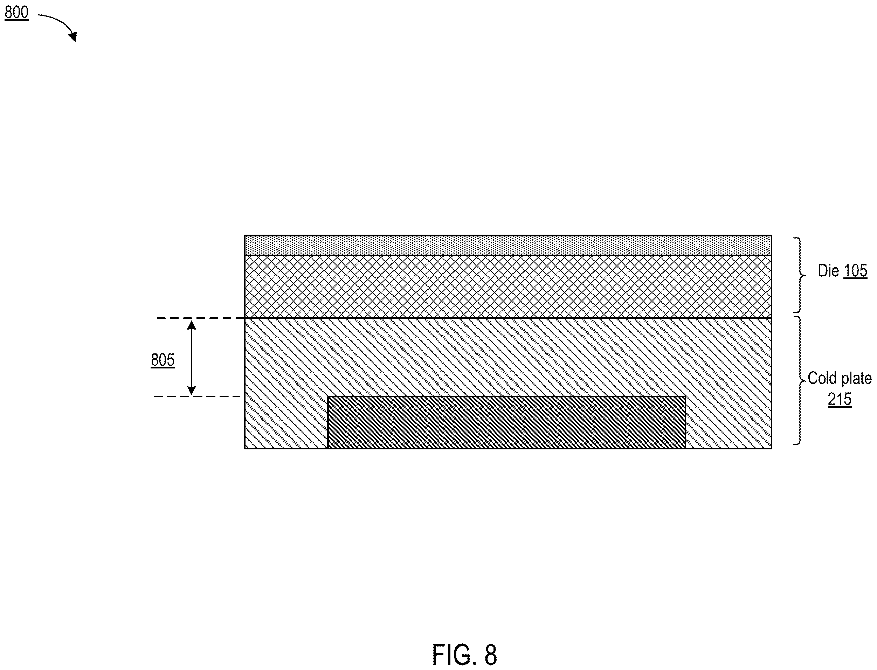

FIG. 8 illustrates an example 800 of a system, structure or device, in accordance with an embodiment of the technical solutions. Example 800 can include the cold plate to device distance being minimized for multi-substrate cold plate designs due to manufacturing techniques, and geometry. The distance 805 between the interior of the fluid channel 250 and a die 105 can be between 0-300 um, such as for example 50 um, for a channel 250 that is 50 um wide. One example distance 805 could be between 50-200 um.

Hybrid bonding can be a technique for connecting two surfaces that include both isolation dielectric and metal pads. Hybrid bonding can form a physically isolating seal to prevent exposure of the conductive material to the cooling fluid. It can minimize the number of materials the fluid is exposed to, which can minimize the possibility of side reactions that could affect system reliability and performance, through corrosion reactions and corrosion product buildup. This approach can maximize the contact area available for making metal connections. This design freedom should enable a high connection density.

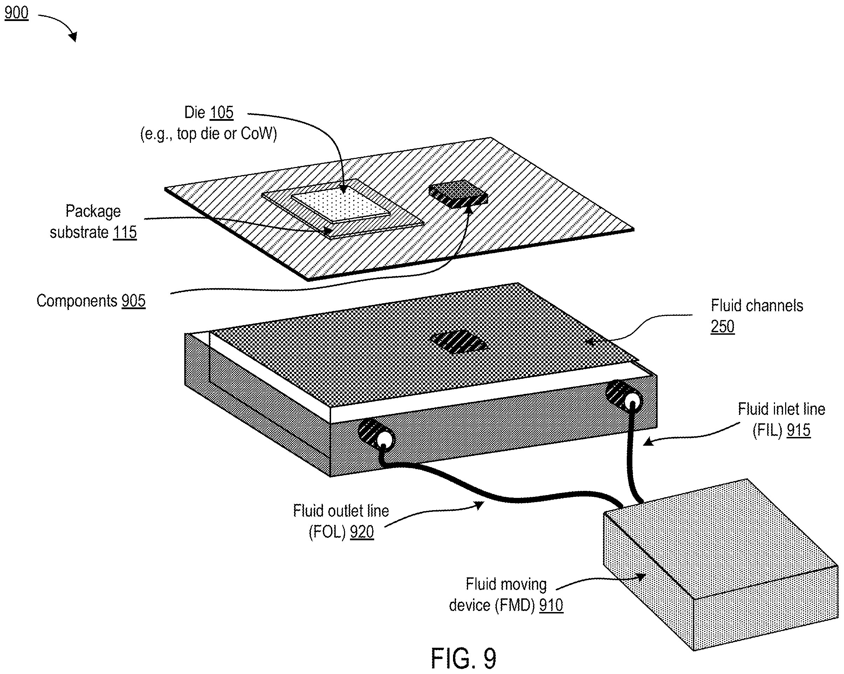

FIG. 9 is an example 900 of a system, structure or device with cold plate with microfluidic channels for backside cooling. A die 105 (e.g., a top die or chip on wafer) can be disposed on a package substrate 115 along with one or more components 905. Components 905 can include other circuits, such as dies 105 with various processors, memories and similar features. Example system 900 can include a fluid moving device 910 for pushing, forcing or moving fluid 255, via fluid inlet line (FIL) 915, through fluid channels 250 beneath the die 105. Once fluid 255 is moved through the channels 250, absorbing the heat from the die 105, fluid 255 can be output from the fluid channels 250, via fluid outlet line (FOL) 920 and brought back to the FMD 910.

Fluid moving device (FMD) 910 can include any combination of hardware and software for moving fluid through channels 250. FMD 910 can include any mechanical or electromechanical system designed to push, move, transport or propel fluids (e.g., gases or liquids) through the one or more fluid channels 250. FMD 910 can be configured to move fluids via fluid outlet lines 920 and fluid inlet lines 915 which can be used to couple the fluid into and out of the fluid channels 250. Fluid moving device 910 can be configured to move the fluid using differential pressure provided by a gravity (e.g., using an elevated fluid tank). FMD 910 can include a micro-pump, which can use mechanisms, such as piezoelectric, electrostatic, or mechanical actuation, to create fluid flow through channels 250. FMD 910 can include a fan or a gas or air blower, such as a fan using spinning blades to generate air movement in electronic systems, to generate airflow through the fluid channels 250 to facilitate gas-based convective cooling. FMD 910 can include a heat exchanger (e.g., a refrigerating device) to cool a fluid moved through FILs 915 and FOLs 920 to reduce the temperature of the fluid 255 and improve heat transfer. FMD 910 can include a fluid inlet line 915 that couples fluid 255 at a first (e.g., lower or cooler) temperature to inlet port 225 and receive fluid 255 from a fluid outlet line 920, via outlet port 230, at a second (e.g., higher or warmer) temperature. FMD 910 can include a water or liquid cooling loop system with a heat exchange system to cool down the fluid 255 received from the cold plate 215 and insert the cooled fluid 255 back into cold plate 215.

Technical solutions can include fluidic channels 250 in the recessed cold plate with components on the interposer of the board and the package substrate with top die 105. The technical solutions can include a hybrid bonded interface at the channel surface, with TSVs on at least one side. For example, the solution can include channels within at least one side of the fluid channel including bonding interface. The solution can include shapes of cooling fins that enable multiple TSVs to pass through. The technical solutions can use TSVs to connect or bond pads at channel hybrid bond interface. The use of TSV outside the microchannel area (outside of the fins) can be implemented, such as to couple to other circuits or substrates.

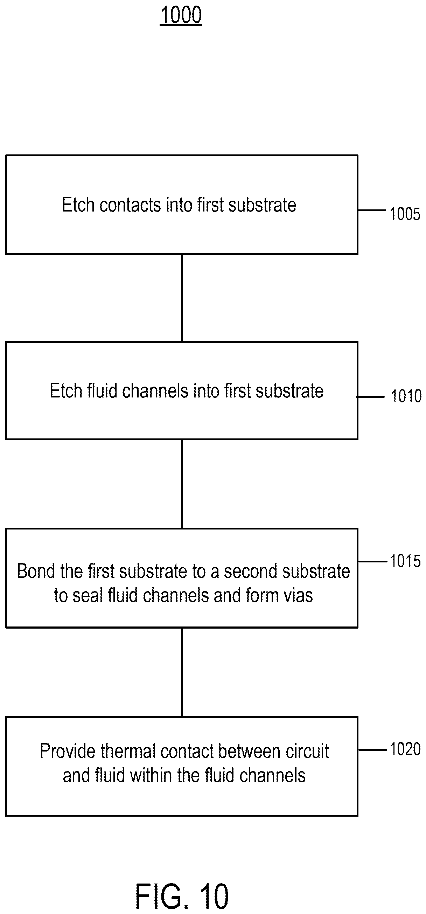

FIG. 10 is an example flow diagram of a method 1000 for providing, to a heat generating circuit, forced fluid convection cooling via one or more channels disposed alongside vertically oriented vias (e.g., TSVs). Method 1000 can include acts 1005 through 1020 that can be implemented, for example, using any combination of features from example structures, devices or systems described in connection with FIGS. 1-9. At 1005, the method can include etching contacts into a first substrate. At 1010, the method can include etching fluid channels into the first substrate. At 1015, the method can include bonding the first substrate to a second substrate to seal fluid channels and form vias. At 1020, the method can include providing thermal contact between a circuit and fluid within the fluid channels.

At 1005, the method can include etching contacts into a first substrate. The method can include etching a plurality of electrical contacts (e.g., parts of through substrate vias or TSVs). The electrical contacts can be etched into the first substrate perpendicularly with respect to a surface of the first substrate. Each of the plurality of electrical contacts (e.g., each part of the TSV etched within the first substrate) can be spaced apart from each other of the plurality of electrical contacts (e.g., parts of TSVs etched in the first substrate).

Parts of the TSVs can be formed by etching perpendicularly downward (e.g., orthogonally to the plane of the surface) one or more trenches, holes, cavities or columns for the parts of the TSVs to be formed. Each trench, hole, cavity or column etched into the first substrate can be oriented or formed perpendicularly with respect to the surface of the first substrate into which the parts of the TSVs are etched or formed. Each etched cavity, trench, hole or column can be cylindrically shaped and have a cross section of a circle, a triangle, a square, a rectangle, a hexagon, decagon, or any other shape. Each etched cavity, trench or a hole can have having a diameter (e.g., along cross section of the etched opening) of about 5-20um and can have a depth (e.g., height along the vertical orientation of the part of the TSV formed in the first substrate) of about 50-300um. An aspect ratio of the height to width of the part of the TSV can be between 1:8 and 1:15, such as 1:10. Trenches (e.g., openings, holes, cavities or cylinders) etched for the electrical contacts in the first substrate can be filled in with electrical conductors, such as copper, aluminum, silver or any other highly electrically conductive material.

Parts of the TSVs can be etched in a line and according to a pitch (e.g., set distances apart) for the parts of the TSVs to be formed in the first substrate. The pitch can be equal for all TSVs or can vary and correspond to an average distance between the TSVs. The parts of the TSVs can be formed within the portions of the first substrate that will include the cooling fins exposed to, or interfacing with, the cooling fluid in the fluid channels. Parts of the TSVs can be etched along a plurality of columns, each column corresponding to a cooling fin of a plurality of cooling fins to be formed in the first substrate.

A second plurality of electrical contacts (e.g., second plurality of parts of the TSVs) to be combined with the parts of the TSVs from the first substrate, can be etched within a second substrate. For example, a second plurality of parts of TSVs can be etched (e.g., as trenches, holes, cavities or columns) perpendicularly with respect to a surface of the second substrate and can be organized in columns or lines with same pitch (e.g., distances apart) and having same diameters and depths as those of the parts of the TSVs in the first substrate. The second plurality of electrical contacts perpendicular with respect to a surface of the second substrate and can be arranged to reflect or match the size, shape and arrangement of the parts of the TSVs formed in the first substrate. The second plurality of electrical contacts formed or etched in the second substrate can match, correspond to or be a mirror image of the plurality of parts of electrical contacts formed or etched in the first substrate. Trenches (e.g., openings, holes, cavities or cylinders) etched for the electrical contacts in the second substrate can be filled in with electrical conductors, such as copper, aluminum, tungsten or any other highly electrically conductive material.

For example, bonding surface can be compatible with hybrid bonding or other surfaces. For instance, the bonding surface can be the top surface of the TSV, or can be a dedicated layer that is formed for the bonding. The surfaces underneath such a surface can use integrated circuit metallization, such as metallization layers, pads or contacts.

At 1010, the method can include etching fluid channels into the first substrate. The method can include etching one or more channels along a surface of the first substrate. The method can include etching a plurality of fluid channels along the surface of the first substrate, each of the plurality of fluid channels etched between one or more of the plurality of electrical contacts. For instance, one or more fluid channels can be etched as elongated trenches, holes, openings or cylinders alongside (e.g., beside of, or adjacent to) the parts of the electrical contacts (e.g., parts of the TSVs) formed or etched within the first substrate. For example, one or more fluid channels can be etched as elongated straight line trenches alongside (e.g., beside) of one or more columns of parts of TSVs etched into the first substrate.

The method can include forming a plurality of fins in the first substrate. Each fin of the plurality of fins can include a projection from a surface configured (e.g,. having shapes and configurations) to facilitate convection of heat to fluid within fluid channels. For example, each cooling fin can be separated from each other cooling fin of the plurality of fins by a fluid channel of the plurality of fluid channels.

Each cooling fin of the plurality of cooling fins can enclose, include or have traversing through it (e.g., along the height of the cooling fin) two or more electrical contacts (e.g., parts of the TSVs) of the plurality of electrical contacts. For example, the respective two or more electrical contacts (e.g., parts of the TSVs) that can be enclosed by each respective fin, can extend vertically along a height of each respective fin. For instance, parts of the TSVs can traverse each of the cooling fins vertically, such that a portion of the first substrate material encloses the column, cavity or elongate part of the TSV's electrical conductor (e.g., copper) along all sides, except the top surface or the bottom surface (e.g., to which parts of the TSVs can be connected to other parts of the TSVs to form TSVs and/or couple with electric circuits).

The method can include creating an inlet port to input a fluid into the plurality of fluid channels and etching an outlet port to output the fluid out of the plurality of fluid channels. For example, an inlet port can be etched or drilled vertically or horizontally with respect to the channel to allow input of the fluid into the fluid channel. For example, an output port can be etched or drilled vertically or horizontally with respect to the channel to allow input of the fluid into the fluid channel.

The method can include coupling to the inlet port a device configured to move the fluid via the inlet port and through the plurality of fluid channels and out of the outlet port. For example, a fluid moving device (e.g., a liquid pump with a heat exchanger for moving liquid fluid or a fan device to move air) can be coupled via fluid input lines and fluid output lines to force movement of fluid through the fluid channels via the input port and the output port. The fluid moving device can input the fluid into the inlet port at a first temperature (e.g., temperature below a first temperature threshold) and can output the fluid, via the outlet port, at a second temperature higher than the first temperature.

At 1015, the method can include bonding the first substrate to a second substrate to seal fluid channels and form vias. The method can include bonding a second substrate to the surface of the first substrate to seal the plurality of fluid channels along the surface of the first substrate. For instance, the first substrate can be bonded to the second substrate using any techniques, such as surface activation, contact bonding (e.g., direct bonding, hybrid bonding, anodic bonding or metallic bonding), or using an annealing (e.g., heating process) to bond two substrates together.

The method can include sealing the plurality of fluid channels between at least the first substrate and the second substrate to facilitate movement of a fluid through the plurality of channels to convect the heat away from the circuit. For example, trenches of the channels etched in the first substrate can be sealed by a second substrate bonded to the first substate, thereby creating fluid channels sealed on all sides, except of the input and output of the fluid channels (e.g., inlet or input port and outlet or output port).

The method can include axially aligning each of the second plurality of electrical contacts with at least one of the plurality of electrical contacts of the first substrate. The method can include bonding the surface of the second substrate with the surface of the first substrate to couple each of the second plurality of electrical contacts with the at least one of the plurality of electrical contacts of the first substrate. The circuit generating heat can be configured to communicate (e.g., send and receive) a plurality of electrical signals via the plurality of electrical contacts and the second plurality of electrical contacts in electrical continuity with the plurality of electrical contacts.

The method can include etching a second plurality of fluid channels along a surface of the second substrate to be bonded to the first substrate. Each of the second plurality of fluid channels can match each of the first plurality of fluid channels etched in the first substrate. The fluid channels in the first substrate and the fluid channels in the second substrate can be mirror images of each other and can have the same arrangement and same features reflecting one another across an axis of the bonding interface between the two substrates.

The method can include aligning each of the second plurality of fluid channels with each respective fluid channel of the plurality of fluid channels to form a combined plurality of fluid channels. Each combined channel of the combined plurality of fluid channels can include a cross section whose height includes a sum of a height of a respective channel of the plurality of channels and a height of a respective channel of the second plurality of channels. The cross section can have a width corresponding to a width of one of the respective channel of the plurality of channels or a width of the respective channel of the second plurality of channels.

The method can include etching a second plurality of electrical contacts etched perpendicular with respect to the surface of the second substrate. Each of the second plurality of electrical contacts can be aligned with a respective of the plurality of electrical contacts of the first substrate. The method can include etching a second plurality of fluid channels along a surface of the second substrate to be bonded to the first substrate. For instance, each of the second plurality of fluid channels can be etched between one or more of the second plurality of electrical contacts.

At 1020, the method can include providing thermal contact between a circuit and a fluid within the fluid channels. The method can include providing a thermal contact between a circuit and the first substrate to facilitate the plurality of fluid channels to dissipate heat from the circuit. For instance, each of the device die, first substrate and the second substrate can include thermal conductor materials (e.g., having thermal conductivity of more than 50 W/m*K). Bonding interface between the device die and the first substrate and the second bonding interface between the first substrate and the second substrate can each facilitate efficient heat conduction to the fluid channels.

The method can include bonding a second surface of a device die with a second surface of the first substrate to conduct the heat from the circuit to the fluid moved, forced or pushed through the channels. The method can include bonding the surfaces of the two substrates to form a bond interface along which the heat is to be conducted between the circuit and the fluid in the fluid channels. The method can bond the device die to the first substrate and the first substrate to the second substrate to allow the heat to be conducted across the bonding interface between the device die and the first substrate and across the bonding interface between the first substrate and the second substrate. The cold plate can be formed using the first substrate and the second substrate to conduct the heat from the circuit, via the device die, via a surface of the device die and the second surface of the first substrate, to a fluid moved through the plurality of fluid channels. The device die can include the circuit having an interconnect layer on a first surface of the device die.

In some instances, the channels can be implemented using only a single substrate (e.g., first substrate and the channels can be sealed using device die (e.g., device layer of the device die). In such configuration, heat generating circuit can be covered with a protective layer of material (e.g., oxide layer) which can be aligned and arranged to be in direct physical contact with the cooling fluid flowing through the fluid channels, to facilitate convection cooling directly from the device die.

When an element is referred to herein as being "connected" or "coupled" to another element, it is to be understood that the elements can be directly connected or coupled the other element, or have intervening elements present between the connected or coupled elements. In contrast, when an element is referred to as being "directly connected" or "directly coupled" to another element, it should be understood that no intervening elements are present in the "direct" connection between the elements. However, the existence of a direct connection does not exclude other connections, in which intervening elements may be present.

When an element is referred to herein as being in "thermal contact" with another element, it is to be understood that the elements can be in direct or physical contact or coupling with the other element, or can have intervening materials, layers, objects or elements present between the two elements. In contrast, when an element is referred to as being in "direct thermal contact" with another element, it should be understood that no intervening elements are present in the "direct" connection between the elements. However, the existence of a direct thermal contact does not exclude other thermal contacts, in which intervening elements may be present.

When an element is referred to herein as being "disposed" beneath or above a particular element, it is to be understood that the elements can be directly located or positioned above or below the other element, or have intervening elements present between the two elements. In contrast, when an element is referred to as being "directly disposed" on or below another element, it should be understood that no intervening elements are present in the "direct" disposition between the elements. However, the existence of a direct disposition does not exclude other disposition, in which intervening elements may be present.

References to "or" may be construed as inclusive so that any terms described using "or" may indicate any of a single, more than one, and all of the described terms. References to at least one of a conjunctive list of terms may be construed as an inclusive OR to indicate any of a single, more than one, and all of the described terms. For example, a reference to "at least one of 'A' and 'B'" can include only 'A', only 'B', as well as both 'A' and 'B'. Such references used in conjunction with "comprising" or other open terminology can include additional items.

It should be noted that certain passages of this disclosure can reference terms such as "first" and "second" in connection with subsets of transmit spatial streams, sounding frames, response, and devices, for purposes of identifying or differentiating one from another or from others. These terms are not intended to merely relate entities (e.g., a first substrate and a second substrate) temporally or according to a sequence, although in some cases, these entities can include such a relationship. Nor do these terms limit the number of possible entities (e.g., delay circuit, filter, peak detector) that can operate within a system or environment. It should be understood that the systems described above can provide multiple ones of any or each of those components and these components can be provided on either a standalone structure or device or, in some embodiments, on multiple structures or devices in a distributed system.

While the foregoing written description of the methods and systems enables one of ordinary skill to make and use embodiments thereof, those of ordinary skill will understand and appreciate the existence of variations, combinations, and equivalents of the specific embodiment, method, and examples herein. The present methods and systems should therefore not be limited by the above described embodiments, methods, and examples, but by all embodiments and methods within the scope and spirit of the disclosure.

## Claims

1. A system (100, 200, 300, 400) comprising:
a plurality of electrical contacts (245) etched in a surface of a first substrate (260), each of the plurality of electrical contacts (245) spaced apart from each other of the plurality of electrical contacts (245);
a plurality of fluid channels (250) etched along the surface of the first substrate (260), each of the plurality of fluid channels (250) etched between one or more of the plurality of electrical contacts (245);
a second substrate (265) bonded to the surface of the first substrate (260) to seal the plurality of fluid channels (250) along the surface of the first substrate (260); and
wherein the plurality of fluid channels (250) dissipate heat from a circuit (210) in thermal contact with the first substrate (260).

2. The system (100, 200, 300, 400) of claim 1, wherein the plurality of fluid channels (250) are sealed between at least the first substrate (260) and the second substrate (265) to facilitate movement of a fluid (255) through the plurality of channels to convect the heat away from the circuit (210).

3. The system (100, 200, 300, 400) of claim 1 or 2, comprising:
a plurality of fins (240) formed in the first substrate (260), each of the plurality of fins (240) separated from each other fin of the plurality of fins (240) by a fluid channel (250) of the plurality of fluid channels (250), wherein each respective fin of the plurality of fins (240) encloses two or more electrical contacts (245) of the plurality of electrical contacts (245), the two or more electrical contacts (245) extending vertically along a height of the each respective fin.

4. The system (100, 200, 300, 400) of any of claims 1 to 3, comprising at least one of the following features:
comprising:
a device die (105) comprising the circuit (210) having an interconnect layer (205) on a first surface of the device die (105), wherein a second surface of the device die (105) is bonded with a second surface of the first substrate (260) at a zero clearance to facilitate conduction of the heat from the circuit (210), via the second surface of the device die (105) and the second surface of the first substrate (260);
comprising:
a second plurality of electrical contacts (245, 510) etched with respect to a surface of the second substrate (265), wherein the surface of the second substrate (265) is bonded with the surface of the first substrate (260) to axially align and couple each of the second plurality of electrical contacts (245, 510) with at least one of the plurality of electrical contacts (245) of the first substrate (260); and
wherein the circuit (210) is configured to communicate a plurality of electrical signals via the plurality of electrical contacts (245) and the second plurality of electrical contacts (245, 510) in electrical continuity with the plurality of electrical contacts (245).

5. The system (100, 200, 300, 400) of any of claims 1 to 4, comprising:
an inlet port (225) to input a fluid (255) into the plurality of fluid channels (250); and
an outlet port (230) to output the fluid (255) out of the plurality of fluid channels (250).

6. The system (100, 200, 300, 400) of claim 5, comprising:
a device (910) configured to move the fluid (255), via the inlet port (225), through the plurality of fluid channels (250) and out of the outlet port (230), the fluid input via the inlet port (225) at a first temperature and output via the outlet port (230) at a second temperature higher than the first temperature.

7. The system (100, 200, 300, 400) of any of claims 1 to 6, comprising:
a second plurality of fluid channels (250) etched along a surface of the second substrate (265) bonded to the first substrate (260), wherein each of the second plurality of fluid channels (250) aligns with each respective fluid channel (250) of the plurality of fluid channels (250) to form a combined plurality of fluid channels (315);

8. The system (100, 200, 300, 400) of claim 7, comprising at least one of the following features:
wherein each combined channel (315) of the combined plurality of fluid channels (315) includes a cross section whose height includes a sum of a height of a respective channel of the plurality of channels and a height of a respective channel of the second plurality of channels, the cross section having a width corresponding to a width of one of the respective channel of the plurality of channels or a width of the respective channel of the second plurality of channels;
wherein each of the second plurality of fluid channels (250) is etched between one or more of a second plurality of electrical contacts (245, 510) etched perpendicular with respect to the surface of the second substrate (265), each of the second plurality of electrical contacts (245, 510) aligned with a respective one of the plurality of electrical contacts (245) of the first substrate (260).

9. A method, comprising:
etching a plurality of electrical contacts (245) in a surface of a first substrate (260), each of the plurality of electrical contacts (245) spaced apart from each other of the plurality of electrical contacts (245);
etching a plurality of fluid channels (250) along the surface of the first substrate (260), each of the plurality of fluid channels (250) etched between one or more of the plurality of electrical contacts (245);
bonding a second substrate (265) to the surface of the first substrate (260) to seal the plurality of fluid channels (250) along the surface of the first substrate (260) to provide a thermal contact between a circuit (210) and the first substrate (260) to facilitate the plurality of fluid channels (250) to dissipate heat from the circuit (210).

10. The method of claim 9, comprising at least one of the following features:
comprising:
sealing the plurality of fluid channels (250) between at least the first substrate (260) and the second substrate (265) to facilitate movement of a fluid (255) through the plurality of channels to convect the heat away from the circuit (210);
comprising:
forming a plurality of fins (240) in the first substrate (260), each fin of the plurality of fins (240) separated from each other fin of the plurality of fins (240) by a fluid channel (250) of the plurality of fluid channels (250); and
enclosing, by each fin of the plurality of fins (240), two or more electrical contacts (245) of the plurality of electrical contacts (245), the respective two or more electrical contacts (245) enclosed by each respective fin extending vertically along a height of the each respective fin;
comprising:
bonding a second surface of a device die (105) with a second surface of the first substrate (260) at a zero-clearance to facilitate conducting the heat from the circuit (210), via the second surface of the device die (105) and the second surface of the first substrate (260), to a fluid (255) moved through the plurality of fluid channels (250), wherein the device die (105) comprises the circuit (210) having an interconnect layer (205) on a first surface of the device die (105);
comprising:
etching a second plurality of electrical contacts (245, 510) perpendicular with respect to a surface of the second substrate (265);
axially aligning each of the second plurality of electrical contacts (245, 510) with at least one of the plurality of electrical contacts (245) of the first substrate (260); and
bonding the surface of the second substrate (265) with the surface of the first substrate (260) to couple each of the second plurality of electrical contacts (245, 510) with the at least one of the plurality of electrical contacts (245) of the first substrate (260), wherein the circuit (210) is configured to communicate a plurality of electrical signals via the plurality of electrical contacts (245) and the second plurality of electrical contacts (245, 510) in electrical continuity with the plurality of electrical contacts (245).

11. The method of claim 9 or 10, comprising:
etching an inlet port (225) to input a fluid (255) into the plurality of fluid channels (250);
etching an outlet port (230) to output the fluid (255) out of the plurality of fluid channels (250); and
coupling to the inlet port (225) a device (910) configured to move the fluid via the inlet port (225), through the plurality of fluid channels (250) and out of the outlet port (230), the fluid input into the inlet port (225) at a first temperature and output via the outlet port (230) at a second temperature higher than the first temperature.

12. The system (100, 200, 300, 400) of any of claims 1 to 8, comprising:
etching a second plurality of fluid channels (250) along a surface of the second substrate (265) to be bonded to the first substrate (260);
aligning each of the second plurality of fluid channels (250) with each respective fluid channel (250) of the plurality of fluid channels (250) to form a combined plurality of fluid channels (315), wherein each combined channel (315) of the combined plurality of fluid channels (315) includes a cross section whose height includes a sum of a height of a respective channel of the plurality of channels and a height of a respective channel of the second plurality of channels, the cross section having a width corresponding to a width of one of the respective channel of the plurality of channels or a width of the respective channel of the second plurality of channels.

13. The method of any of claims 9 to 11, comprising:
etching a second plurality of electrical contacts (245, 510) etched perpendicular with respect to the surface of the second substrate (265), each of the second plurality of electrical contacts (245, 510) to be aligned with a respective of the plurality of electrical contacts (245) of the first substrate (260);
etching a second plurality of fluid channels (250) along a surface of the second substrate (265) to be bonded to the first substrate (260), wherein each of the second plurality of fluid channels (250) is etched between one or more of the second plurality of electrical contacts (245, 510).

14. A device for cooling a circuit (210), comprising:
a first semiconductor substrate (260) having a first metal component extending from a first surface of the first semiconductor substrate (260) toward an interior of the first semiconductor substrate (260) and a channel (250) etched into and along the first surface of the first semiconductor substrate (260);
a second semiconductor substrate (265) having a second metal component extending from a first surface of the second semiconductor substrate (265) towards an interior of the second semiconductor substrate (265);
an interface along which the first surface of the first semiconductor substrate (260) is bonded with the first surface of the second semiconductor substrate (265) to seal a fluid (255) inside the channel (250) between the first semiconductor substrate (260) and the second semiconductor substrate (265) and form a metal via from the first metal component coupled with the second metal component; and
a device die (105) in thermal contact with the first semiconductor substrate (260) via a second interface along which the device die (105) is bonded with the a second surface of the first semiconductor substrate (260) to dissipate heat generated by a circuit (210) in the device die (105) to the fluid (255) in the channel (250) and electrically connect the metal via to the circuit (210).

15. The device of claim 14, comprising:
a plurality of channels (250) comprising the channel (250), the plurality of channels (250) etched along the first surface of the first substrate (260);
an inlet port (225) to facilitate input of the fluid (255) into the plurality of channels (250); and
an outlet port (230) to facilitate output of the fluid (255) from the plurality of channels (250).
